(19) Europäisches Patentamt
European Patent Office
Office européen des brevets

(11) Publication number: 0 032 463
A1

(12) # EUROPEAN PATENT APPLICATION

(21) Application number: 81300237.5

(22) Date of filing: 20.01.81

(51) Int. Cl.[3]: C 25 D 3/26
C 25 D 3/54, C 25 D 7/12
H 01 L 31/18

(30) Priority: 21.01.80 US 114045

(43) Date of publication of application:
22.07.81 Bulletin 81/29

(84) Designated Contracting States:
AT BE CH DE FR GB IT LI LU NL SE

(71) Applicant: Inco Research & Development Center, Inc.
Sterling Forest
Suffern New York 10901(US)

(72) Inventor: Clark, William Donald Kennedy
19, Park Avenue
Warwick New York 10990(US)

(72) Inventor: Hall, Dale Edward
14, Midoaks Road
Monroe New York 10950(US)

(74) Representative: Greenstreet, Cyril Henry
Thames House (Fifth floor) Millbank
London SW1P 4QF(GB)

(54) **Electrodeposition of cadmium with selenium.**

(57) In a process for electrodepositing a cadmium-selenium coating on a cathodic substrate, the cadmium and selenium are codeposited from an aqueous acidic bath containing citrate ions, cadmium and selenium.

EP 0 032 463 A1

Croydon Printing Company Ltd.

# Electrodeposition of Cadmium with Selenium

This invention relates to a process and bath for the electrodeposition of cadmium-selenium coatings, and to the production of cadmium-selenium coated photo-electrodes for photovoltaic cells.

It is known to make photoelectrodes for photovoltaic cells by electrodepositing a thin, semi-conducting cadmium-selenium layer on to a substrate having a fairly high electrical conductivity. The bath used is commonly an acid sulphate bath of very low pH, typically from 0 to 1 pH units, but the range of proportions in which cadmium and selenium can be deposited from such baths is limited.

The present invention is based on the discovery that cadmium-selenium coatings having cadmium contents at least in the range 35 to 75% by weight can be obtained by the use of an aqueous acidic citrate bath.

According to the invention, cadmium and selenium are codeposited on a cathodic substrate from an aqueous acidic bath containing citrate ions as well as cadmium and selenium.

The citrate ions may be introduced into the bath by dissolving citric acid and soluble citrates, e.g. sodium citrate in water. Other anions that do not adversely affect the electrodeposition may be present. Thus the cadmium may be introduced into the bath as any common soluble cadmium salt, e.g. cadmium chloride ($CdCl_2$) or cadmium sulphate ($CdSO_4$). Selenium may be introduced as selenious acid ($H_2SeO_3$) or selenium dioxide ($SeO_2$).

To obtain an electrodeposit having a high ratio of cadmium to selenium, the mole ratio of cadmium to selenium in the bath should be at least 5:1 and preferably 30:1 or more. The composition of the deposit also depends on the pH of the bath: within the preferred pH range from 1 to 3, the proportion of selenium is higher at the upper end of the range.

The cathode current density during the electrodeposition should be at least 1 $mA/cm^2$, higher current

densities being required as the ratio of cadmium to selenium in the bath is increased.

The bath may be used to deposit cadmium-selenium coatings on to cathodes of any material having a high enough electrical conductivity. The substrate may be either metallic or non-metallic, e.g. a metal oxide thin film.

The anodes employed in the process may either be inert, e.g. of graphite or platinum, or soluble anodes of cadmium, selenium or both. The use of a soluble selenium anode is a particularly suitable way of replenishing the bath in selenium. To achieve a proper balance between anodic dissolution and cathodic deposition of cadmium and selenium, combinations of inert and soluble anodes may also be used.

The process and bath of the invention are particularly suitable for the production of cadmium-selenium coated thin film semiconductor photoelectrodes. For these, the cathodic substrate on which the coating is deposited is preferably a material such that there is ohmic or nearly ohmic contact between it and the electrodeposit. One such material is titanium, which has the further advantage of not corroding in the presence of the electrolytes used in photoelectrochemical cells. It is preferred to roughen the surface of the substrate before plating, in order to improve the adhesion of the deposit. The cadmium-selenium deposit should contain at least 35% by weight of cadmium, and to improve the photo-current-generating ability of the photoelectrode it is advantageously heat treated before use.

By way of example, a titanium metal cathode was coated with cadmium and selenium by electrodeposition from a bath having the following composition, using baskets of platinised titanium as anodes.

| | Moles/ Litre | Grams/ Litre | Ratio |
|---|---|---|---|
| $C_3H_4(OH)(COOH)_3.H_2O$ (hydrated citric acid) | 0.286 | 60 | |
| $Na_3C_6H_5O_7.H_2O$ (hydrated sodium citrate) | 0.272 | 80 | |
| $CdCl_2.2\frac{1}{2}\ H_2O$ (hydrated cadmium chloride) | 0.788 | 180 | |
| $H_2SeO_3$ (selenious acid) | 0.0186 | 2.4 | |
| Total Citrate Moiety | 0.558 | 107.10 | |
| Total $Na^+$ | 0.816 | 18.77 | |
| Total $Cd^{++}$ | 0.788 | 88.60 | |
| Total $Cl^-$ | 1.576 | 56.0 | |
| $Na^+$ / (citrate) | | | 1.46 |
| $Cd^{++}$/ (Se) | | | 42.36 |

Plating was effected at a current density of 3.2 $mA/cm^2$ in a stirred solution for 60 minutes at $35^oC$. The deposit obtained was heat treated at $550^oC$ for 15 minutes to improve its photocurrent generating capabilities. The deposit was then analyzed and was found to contain 54 weight per cent cadmium.

The coated titanium product was used as a photoelectrode in a photoelectrochemical cell containing 1M NaOH/1M NaS/1M S as the redox electrolyte. When the cell was exposed to light from a xenon lamp equipped with a solar simulator filter, an open circuit voltage ($V_{oc}$) of 0.19 volts and a short circuit current density ($I_{sc}$) of 1.0 $mA/cm^2$ was obtained. The energy conversion efficiency of the electrode was approximately 0.8%.

The chemistry of the process of the invention will now be discussed briefly. In aqueous acids, selenium added to the plating solution as selenious acid (as in the above example) is subject to the following equilibria:

1) $H_2SeO_3 \rightleftharpoons H^+ + HSeO_3^-$ at pH 2.57

and

2) $HSeO_3^- \rightleftharpoons H^+ + SeO_3^{2-}$ at pH 6.58

In an acid citrate solution maintained at pH 3, 27% of the selenium in solution was present as $H_2SeO_3$ and the remaining 73% was in the form of $HSeO_3^-$. (The amount of the doubly ionized form was negligible).

The reactions and standard potentials for the deposition of selenium from an acid citrate solution are as follows:

$$3)\quad H_2SeO_3 + 4e^- + 4H^+ \rightleftharpoons Se + 3H_2O$$

$$E_1^o = 0.536-0.074 = 0.314 \text{ V/SCE at pH 3}$$

(SCE = standard calomel electrode)

and

$$4)\quad HSeO_3^- + 4e^- + 5H^+ \rightleftharpoons Se + 3H_2O$$

$$E_2^o = 0.499-0.059 = 0.322 \text{ V/SCE at pH 3}$$

In an acid citrate solution containing 2.4 grams/litre of selenious acid, the equilibrium potentials of each species, taking into account their relative concentrations and equations 3 and 4 above, are:

$$5)\quad E_{eq1} = 0.288 \text{ V/SCE for } H_2SeO_3/Se$$

and

$$6)\quad E_{eq2} = 0.286 \text{ V/SCE for } H_2SeO_3$$

The cathodic deposition of cadmium from aqueous acid electrolytes is described by:

$$7)\quad Cd^{+2} + 2e^- \rightleftharpoons Cd$$

$$E^o = -0.645 \text{ V/SCE}$$

and in an acid citrate bath containing 180 g/l of $CdCl_2 \cdot 2\frac{1}{2}H_2O$ the equilibrium potential is given by:

$$8)\quad E_{eq,}\ Cd = -0.648 \text{ V/SCE for } Cd^{+2}/Cd$$

The large difference in equilibrium potential for selenium and cadmium ($\Delta$ Eeq = 0.934 V from expressions 6 and 8) makes the codeposition of elemental selenium and cadmium difficult and there is a much greater tendency for selenium to deposit than cadmium. It has been suggested that the first stage in codeposition is the deposition of a Se atom. A Cd atom is then deposited at this nucleation site to form CdSe. Usually codeposition of elements with

such large differences in their equilibrium potentials requires the use of complexing agents to retard deposition of the more easily-deposited species. However, we have found that the process of the invention facilitates the codeposition of selenium and cadmium. Moreover, the citrate bath is buffered against pH changes in the cathode diffusion layer which may arise from selenium deposition (equations 3 and 4). Finally, by operating at a relatively high pH level, the tendency to separation of the equilibrium potentials for cadmium and selenium deposition is reduced.

## Claims

1. A process for electrodepositing a cadmium-selenium coating on a cathodic substrate, characterised in that the cadmium and selenium are codeposited from an aqueous acidic bath containing citrate ions, cadmium and selenium.

2. A process according to claim 1, characterised in that the pH of the bath is maintained in the range from 1 to 3 pH units.

3. A process according to claim 1 or claim 2 characterised in that the bath is wholly or completely replenished with cadmium, selenium or both by dissolution of soluble anodes.

4. A process according to any preceding claim, characterised in that the cathode current density is at least 1 $mA/cm^2$.

5. A process according to any preceding claim, characterised in that a cadmium-selenium coating containing at least 35% by weight of cadmium is deposited on a titanium substrate to form a photoelectrode.

6. A process according to claim 5, characterised in that the coated substrate is heat treated to increase its photocurrent generating ability.

7. A cadmium-selenium electroplating bath for use in a process according to claim 1, characterised in that it consists of an aqueous acidic solution containing citrate ions, cadmium and selenium.

8. A bath according to claim 7, characterised in that it contains citric acid, and soluble metal citrate and has a pH in the range from 1 to 3 pH units.

9. A bath according to claim 7 or claim 8, characterised in that the mole ratio of cadmium to selenium in the bath is at least 5:1.

10. A bath according to claim 9, characterised in that it comprises an aqueous acid solution of citric acid, sodium citrate, a soluble cadmium salt and selenious acid or selenium dioxide.

0032463

European Patent Office

# EUROPEAN SEARCH REPORT

Application number

EP 81300237.5

| Category | DOCUMENTS CONSIDERED TO BE RELEVANT<br>Citation of document with indication, where appropriate, of relevant passages | Relevant to claim | CLASSIFICATION OF THE APPLICATION (Int. Cl.³) |
|---|---|---|---|
| | DE - A1 - 2 819 759 (EURATOM)<br>+ Claims +<br>-- | 1 | C 25 D 3/26<br>C 25 D 3/54<br>C 25 D 7/12<br>H 01 L 31/18 |
| | GB - A - 1 226 917 (KENVERT INTERNATIONAL CORPORATION)<br>+ Claims +<br>---- | 1 | |
| | | | TECHNICAL FIELDS SEARCHED (Int. Cl.³)<br>C 25 D<br>H 01 L |
| | | | CATEGORY OF CITED DOCUMENTS<br>X: particularly relevant<br>A: technological background<br>O: non-written disclosure<br>P: intermediate document<br>T: theory or principle underlying the invention<br>E: conflicting application<br>D: document cited in the application<br>L: citation for other reasons |
| X | The present search report has been drawn up for all claims | | &: member of the same patent family, corresponding document |

| Place of search | Date of completion of the search | Examiner |
|---|---|---|
| VIENNA | 18-03-1981 | SLAMA |

EPO Form 1503.1 06.78